# FASCICULE DE BREVET EUROPEEN

(11) **EP 3 748 373 B1**
(45) Date de publication et mention de la délivrance du brevet: **04.08.2021**
(21) Numéro de dépôt: 20177077.3
(22) Date de dépôt: 28.05.2020
(51) Int. Cl.: G01R 19/25, H02J 3/00, H02J 13/00, G06Q 50/06, H02J 3/26

(54) **DIAGNOSTIC DE RESEAU DE DISTRIBUTION ÉLECTRIQUE**
DIAGNOSE FÜR ELEKTRISCHES VERTEILUNGSNETZWERK
DIAGNOSIS OF ELECTRICAL DISTRIBUTION NETWORK

(30) Priorité: 07.06.2019 FR 1906085
(43) Date de publication de la demande: 09.12.2020
(73) Titulaire: Enedis, 92079 Paris La Defense Cedex (FR)
(72) Inventeur: ROUPIOZ, Guillaume, 74000 ANNECY (FR); GORGETTE, Frédéric, 94240 L'HAY LES ROSES (FR); LEVAUFRE, Simon, 69300 CALUIRE ET CUIRE (FR)
(74) Mandataire: Plasseraud IP

(56) Documents cités:
- EP-A1- 3 026 773
- EP-A1- 3 223 022
- US-A1- 2011 066 301
- US-A1- 2012 022 713
- US-A1- 2014 330 441

## Description

### Domaine technique

La présente divulgation relève du domaine de la gestion et de l'entretien d'un réseau de distribution électrique.

### Technique antérieure

Pour détecter les parties d'un réseau de distribution électrique les plus susceptibles de subir une défaillance, il est connu d'effectuer périodiquement des simulations. De telles simulations sont effectuées sur une topologie de réseau théorique sensée correspondre à la topologie du réseau réel et avec des contraintes théoriques de fonctionnement sévères mais inspirées de la réalité. Dans l'exemple d'un réseau électrique, on simule par exemple de basses températures et des consommations élevées via un grand nombre de nœuds consommateurs. Des valeurs physiques telles que la tension sont évaluées. Lorsque des excursions hors d'une plage considérée comme « acceptable » sont détectées, des alertes sont générées. Un diagnostic ciblé et précis peut alors être effectué sur le réseau réel. Ensuite seulement, des mesures correctives peuvent être prises (interventions de maintenance). Avec un tel procédé, le temps long s'écoule entre l'apparition d'un défaut ou d'une faiblesse du réseau et l'amélioration de la situation. En outre, certains paramètres des réseaux réels ne sont pas (ou mal) référencés et ne peuvent donc pas être pris en compte par les simulations. Par exemple, la répartition des nœuds fournisseurs et/ou consommateurs sur chacune des phases d'un réseau électrique triphasé peut être mal renseignée dans les bases de données du gestionnaire de réseau. Les anomalies résultant de déséquilibres de phases sont alors impossibles à prévoir par de telles méthodes de simulation.

La méthode la plus rapide pour identifier une défaillance reste l'alerte humaine, typiquement par un utilisateur d'un nœud de consommation détectant une anomalie. Cependant, la précision des informations recueillie est souvent insuffisante, dans un premier temps, pour planifier une intervention corrective pertinente. Il est souvent nécessaire qu'un opérateur effectue des constations complémentaires, y compris en mettant en place une surveillance sur plusieurs jours. Le temps s'écoulant entre la survenance d'une anomalie et la mise en place de mesures correctrices reste donc important.

Depuis peu, un grand nombre de nœuds des réseaux de distribution peuvent être équipés de dispositifs communicants. Par exemple, le document EP3223022 A1 divulgue un procédé de diagnostic d'un réseau électrique. En outre, des « compteurs communicants » connus sous la référence commerciale « Linky » sont en cours de déploiement en France. De tels compteurs comprennent un module de communication apte à transmettre des données à distance de manière au moins en partie automatisée. De tels modules sont agencés pour transmettre, à intervalle régulier, des informations relatives à la consommation et/ou à la production, notamment dans un but de facturation.

De tels dispositifs communicants répartis sur une grande partie du réseau pourraient en théorie être utilisés pour assurer une surveillance étendue et en temps réel du réseau. Il est techniquement possible de traiter l'ensemble de ces données pour effectuer du diagnostic de réseau à distance. Cependant, cela implique de collecter et centraliser un grand nombre de données, y compris des données considérées comme sensibles et des données « personnelles » (relatives par exemple à des consommations d'énergie horodatées, localisées et personnalisées). Pour des raisons légales, de sécurisation d'accès aux données, et au moins pour des considérations morales, il est hautement souhaitable de limiter la collecte et la centralisation de telles données. Autrement dit, sont combinées ici la problématique usuelle d'entretien des réseaux et celle de la sécurisation des données.

En outre, collecter, centraliser et traiter un grand volume de données détaillées implique une consommation de bande passante, de ressources informatiques et d'énergie importante qu'il est souhaitable de limiter, en particulier dans un contexte de surveillance en temps réel.

Il est également souhaitable de pouvoir automatiser en partie au moins de tels processus au point que certaines étapes de traitement des données sont dépourvues de toute intervention humaine.

### Résumé

La présente divulgation vient améliorer la situation.

Il est proposé un procédé de diagnostic d'un réseau électrique incluant une pluralité de nœuds, chaque nœud étant équipé d'un dispositif local apte à mesurer au moins une propriété de l'énergie électrique transitant via le nœud correspondant, le procédé comprenant :
a) enregistrer des évènements par chaque dispositif local, chaque évènement étant défini au moins par un identifiant du nœud et/ou du dispositif local, une date et une valeur quantifiant une anomalie dans l'au moins une propriété mesurée ;
b) effectuer une collecte générale des enregistrements de chaque dispositif local, relatifs à une plage temporelle commune, sur un dispositif central relié au réseau ;
c) compléter chaque événement collecté par des données d'arborescence du réseau à la date de l'évènement, de sorte que des modifications du réseau pouvant avoir une influence sur l'au moins une propriété mesurée à la date de l'évènement soient identifiables ;
d) comparer les évènements à des données d'historique de modifications du réseau de manière à distinguer des premiers événements non imputables auxdites modifications de seconds évènements imputables auxdites modifications ;
e) ordonnancer les premiers évènements les uns par rapport aux autres en fonction de règles préétablies de pertinence et/ou de priorité ;
f) sélectionner une partie des premiers évènements en fonction de l'ordonnancement ;
g) enrichir les données de ladite sélection en effectuant une collecte ciblée de données supplémentaires de chaque dispositif local identifié dans ladite sélection.

Selon un autre aspect, il est proposé un programme informatique comportant des instructions pour la mise en œuvre de tout ou partie d'un procédé tel que défini dans les présentes lorsque ce programme est exécuté par un processeur. Selon un autre aspect, il est proposé un support d'enregistrement non transitoire, lisible par un ordinateur, sur lequel est enregistré un tel programme.

Les caractéristiques exposées dans les paragraphes suivants peuvent, optionnellement, être mises en œuvre. Elles peuvent être mises en œuvre indépendamment les unes des autres ou en combinaison les unes avec les autres :
Le procédé peut comprendre en outre, après l'opération d'enrichissement : h. simuler, en au moins un nœud, au moins une situation déduite des données enrichies obtenues.

Le procédé peut comprendre en outre :
i. simuler, en au moins un nœud, une situation dans laquelle au moins une intervention sur le réseau a été effectuée par rapport à au moins une situation déduite des données enrichies obtenues.

Dans le procédé, l'au moins une intervention inclut au moins un rééquilibrage de phases d'une ligne triphasée et/ou un changement de prise d'un transformateur.

Dans le procédé, l'au moins une intervention inclut au maximum trois interventions parmi des rééquilibrages de phases d'une ligne triphasée et des changements de prise d'un transformateur.

Le procédé peut comprendre en outre :
j. éditer au moins un rapport d'intervention en fonction d'un diagnostic déduit des données enrichies.

### Brève description des dessins

D'autres caractéristiques, détails et avantages apparaîtront à la lecture de la description détaillée ci-après, et à l'analyse des dessins annexés, sur lesquels :
**Fig. 1**

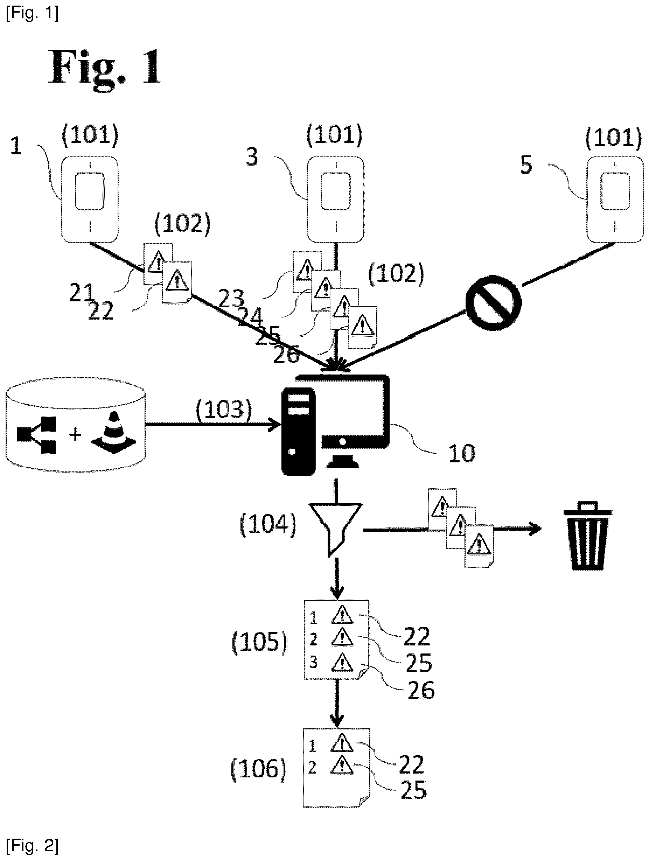

   [Fig. 1] montre un diagramme de mise en œuvre d'une partie d'un procédé selon un mode de réalisation.
**Fig. 2**

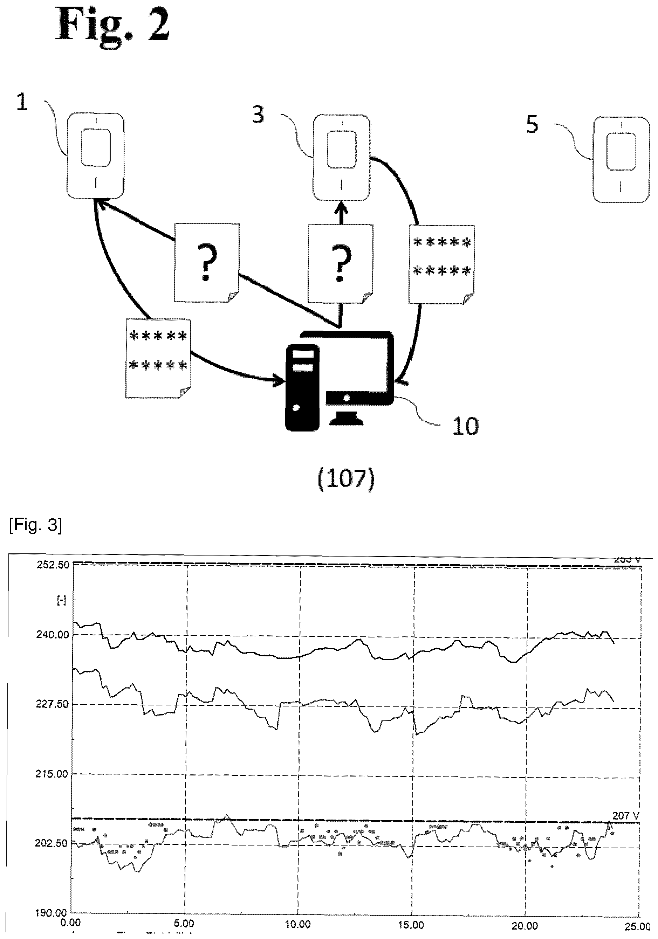

   [Fig. 2] montre un diagramme de mise en œuvre d'une partie d'un procédé selon un mode de réalisation.
**Fig. 3**
   [Fig. 3] montre un graphique de tensions sur trois phases avant mise en œuvre d'un procédé selon un mode de réalisation.
**Fig. 4**

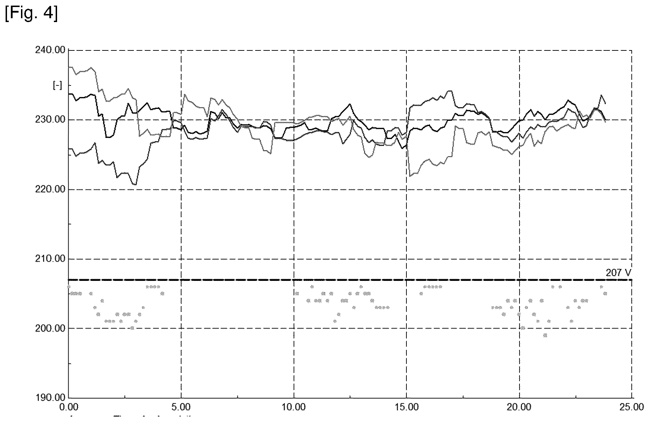

   [Fig. 4] montre un graphique de tensions sur trois phases après mise en œuvre d'un procédé selon un mode de réalisation.

### Description des modes de réalisation

Les dessins et la description ci-après pourront non seulement servir à mieux faire comprendre la présente divulgation, mais aussi contribuer à sa définition, le cas échéant.

Il est maintenant fait référence à la [Fig. 1]. Sur cette figure, une première partie d'un procédé est représentée. Il s'agit d'un procédé de diagnostic d'un réseau électrique incluant une pluralité de nœuds.

Dans un réseau de distribution d'électricité, on distingue habituellement des nœuds amonts et des nœuds avals. Par exemple, un nœud amont correspond à un transformateur disposé entre le réseau de transport moyenne tension (ou haute tension type A HTA) et le réseau de distribution basse tension (BT) en aval. Le réseau basse tension (BT), choisi en exemple, présente une structure arborescente. Le sommet de la structure arborescente correspond au nœud amont, matérialisé par un poste de transformation HTA/BT. Chaque nœud aval forme un point de branchement le long d'un des tronçons du réseau. Les nœuds avals correspondent sensiblement aux « Points De Livraison (PDL) » lorsqu'il s'agit de nœuds consommateurs. Les nœuds avals comprennent en outre des nœuds producteurs, ou fournisseurs, à partir desquels de l'énergie est fournie au réseau. Par exemple, des installations de type éolienne ou panneau photovoltaïque peuvent être reliées au réseau de distribution. Un nœud aval peut être un nœud consommateur et un nœud producteur. Chaque nœud aval forme une interface entre le réseau de distribution et un réseau électrique secondaire, généralement privé, par exemple un réseau électrique domestique.

Dans l'exemple décrit ici, chaque nœud (amont ou aval) est matérialisé par au moins un dispositif local 1, 3, 5 optionnellement combiné à d'autres équipements. Un nœud aval présente, par exemple, un compteur propre à comptabiliser la consommation et/ou la fourniture d'électricité du réseau secondaire à des fins de facturation.

Chacun des dispositifs locaux 1, 3, 5, et par extension chaque nœud, est équipé d'au moins un module de communication et d'une mémoire apte à stocker des données. Ainsi, chaque dispositif local 1, 3, 5 est apte à mettre en œuvre une opération d'enregistrement telle que décrite ci-après (opération 101). Le module de communication, ou interface de communication, est apte à échanger des données avec au moins un autre nœud du réseau. Ici, les modules de communication échangent des données par Courant Porteur en Ligne (CPL). Lorsque cela est nécessaire, des nœuds intermédiaires peuvent former relais pour permettre au dispositif local 1, 3, 5 de chaque nœud de communiquer avec un dispositif central 10 connecté au réseau.

Le dispositif central 10 comprend un ensemble de modules informatiques propres à recevoir, stocker et traiter des données. Le dispositif central 10 inclut au moins une unité de traitement de données. L'unité de traitement inclut quant à elle au moins un processeur couplé de manière opérationnelle avec au moins une mémoire pour mettre en œuvre au moins en partie un procédé tel que défini dans les présentes (par exemple les opérations 102 à 107 décrites ci-après).

Dans la suite, on considère que le dispositif central 10, ou « concentrateur », est situé au niveau d'un nœud amont. En variante, le dispositif central 10 peut être déporté par rapport au nœud amont. Le dispositif central 10 peut communiquer avec les dispositifs locaux 1, 3, 5 par CPL via le réseau de distribution électrique lui-même et/ou via d'autres réseaux de communication tels que les réseaux de téléphonie mobile. Le dispositif central 10 peut inclure des éléments physiquement distants les uns des autres et/ou distants du nœud amont.

Chaque dispositif local 1, 3, 5 est apte à mesurer au moins une propriété de l'énergie électrique fournie au nœud correspondant. Dans les exemples qui suivent, la propriété qui est mesurée et surveillée est la tension. Le lecteur comprendra que les exemples sont aisément transposables à d'autres propriétés physiques de l'électricité.

Le procédé peut être décomposé selon les opérations telles que définies ci-après :
a. enregistrer 101 des évènements 21, 22, 23, 24, 25, 26 par chaque dispositif local 1, 3, 5 ;
b. effectuer 102 une collecte générale des enregistrements de chaque dispositif local, relatifs à une plage temporelle commune, sur le dispositif central 10 relié au réseau ;
c. compléter 103 chaque évènement collecté par des données d'arborescence du réseau à la date de l'évènement, de sorte que des modifications du réseau pouvant avoir une influence sur l'au moins une propriété mesurée à la date de l'évènement soient identifiables ;
d. comparer 104 les évènements à des données d'historique de modifications du réseau de manière à distinguer des premiers événements 22, 25, 26 non imputables auxdites modifications de seconds évènements 21, 23, 24 imputables auxdites modifications ;
e. ordonnancer 105 les premiers évènements les uns par rapport aux autres en fonction de règles préétablies de pertinence et/ou de priorité ;
f. sélectionner 106 une partie des premiers évènements 22, 25 en fonction de l'ordonnancement ;
g. enrichir 107 les données de ladite sélection en effectuant une collecte ciblée de données supplémentaires de chaque dispositif local identifié dans ladite sélection.

Les enregistrements 101 sont mis en œuvre par chaque dispositif local 1, 3, 5, ici indépendamment les uns des autres. Les enregistrements ont donc lieu, à ce stade, seulement sur la mémoire de chaque dispositif local 1, 3, 5. Autrement dit, les enregistrements ne sont pas centralisés à ce stade : accéder aux données stockées sur un dispositif local 1, 3, 5 ne permet pas d'accéder aux données stockées sur d'autres dispositifs locaux.

Par « événement », on entend viser ici un jeu de données définissant une situation horodatée, et considérée comme anormale ou inhabituelle, détectée par l'intermédiaire d'un dispositif local 1, 3, 5. Aussi, chaque évènement est défini au moins par :
- un identifiant du nœud et/ou du dispositif local,
- une date, et
- une valeur quantifiant une anomalie dans l'au moins une propriété mesurée.

L'identifiant permet ultérieurement, par comparaison avec une base de données topologique du réseau, de localiser l'évènement sur le réseau en fonction de la position du nœud sur le réseau. Par « date » on entend viser ici toute information permettant d'horodater l'évènement. En fonction du niveau de précision souhaité, la date peut définir seulement un jour ou être plus précise jusqu'à dater l'évènement à la seconde près.

Dans les exemples représentés notamment sur les [Fig. 3] et [Fig. 4], la valeur quantifiant l'anomalie est une tension (en Volts). Dans l'exemple décrit ici, les « événements » sont définis comme étant des excursions de tension en dehors d'une plage de tension considérée comme normale. Les bornes de la plage de tension normale est, par exemple, définie dans la norme NF EN-50 160 (février 2011). La norme NF EN-50 160 définit de manière plus générale les divers paramètres de la qualité de l'énergie électrique fournie. En variante, d'autres valeurs physiques, notamment celles définies dans ladite norme, peuvent être utilisées pour définir un « événement ». Un « événement » peut aussi être défini par une combinaison de paramètres.

La collecte générale 102 des enregistrements de chaque dispositif local 1, 3, 5 comprend la transmission des enregistrements locaux depuis chaque nœud jusqu'au dispositif central 10. Dans les exemples décrits ici, la collecte 102 est mise en œuvre périodiquement, par exemple une fois toutes les 24 heures. La période de collecte de 24 heures correspond à la période par défaut de relève des données des compteurs communiquant commercialisés sous le nom « Linky » et mis en œuvre par la demanderesse. Ainsi, la collecte générale 102 des enregistrements d'évènements peut être concomitante des relevés de consommation électrique à visée de facturation. Cela permet de limiter le nombre de mise en communication de chaque dispositif local 1, 3, 5 avec des équipements distants sur le réseau. En variante, l'opération de collecte peut être mise en œuvre à des périodes distinctes. Par exemple, lorsque l'on souhaite effectuer une surveillance fine d'un ensemble de dispositifs locaux 1, 3, 5 particuliers, la période de collecte peut être temporairement réduite. Dans certains cas, la collecte générale 102 peut même être effectuée sensiblement en continu pour effectuer une surveillance en temps réel, par exemple pendant une phase d'essai ou de calibration.

En fonctionnement normal, la collecte générale 102 d'enregistrements issus de plusieurs dispositifs locaux 1, 3, 5 est mise en œuvre de sorte que les informations collectées sont relatives à des évènements s'étant produits sur une plage de temps commune.

Chaque évènement collecté par le dispositif central 10 est complété 103 par le dispositif central 10. Des données d'arborescence du réseau à la date de l'évènement viennent compléter chaque évènement. Pour cela, des données relatives à l'arborescence, ou la topologie, du réseau sont rendues accessibles au dispositif central 10. De telles données sont par exemple stockées et mises à jour sur la mémoire du dispositif central 10.

Dans l'exemple décrit ici, par comparaison de telles données d'arborescence avec l'identifiant de chaque évènement, le dispositif central 10 établit, pour chaque évènement, un « chemin électrique ». Le chemin électrique comprend, par exemple, une identification des éléments, au moins ceux du réseau, situés électriquement entre la source de l'énergie électrique consommée et le dispositif local (ou le nœud) identifié dans l'évènement. Le chemin électrique comprend des équipements théoriquement passifs tels que des câbles et des connecteurs, et des équipements actifs tels que des transformateurs.

En complétant ainsi les évènements par des données de contexte, il est ultérieurement possible d'établir des liens de causalité avec des paramètres extérieurs au dispositif local via lequel l'évènement a été relevé. Par exemple, des modifications du réseau pouvant avoir une influence sur l'au moins une propriété mesurée à la date de l'évènement deviennent identifiables.

Le dispositif central 10 a en outre accès à des données d'historique de modifications du réseau. Les données d'historique contiennent, par exemple, des informations datées relatives à des dysfonctionnements des éléments du réseau tels que des équipements temporairement hors-services, y compris dont le rétablissement a déjà eu lieu ou est déjà planifié. Les évènements détectés via les dispositifs locaux et complétés par un chemin électrique sont ainsi comparés, par le dispositif central 10, aux données d'historique. La comparaison permet de distinguer des premiers évènements 22, 25, 26 non imputables auxdites modifications de seconds évènements 21, 23, 24 imputables auxdites modifications. Une telle distinction permet d'éviter d'enquêter plus précisément sur les causes d'un évènement alors même que l'origine de l'évènement est probablement l'un des dysfonctionnements historisés. Autrement dit, les ressources tant informatiques qu'humaines peuvent être utilisées préférentiellement pour identifier et résoudre des événements dont l'origine est encore inconnue à ce stade plutôt que pour des évènements dont la résolution est déjà en cours ou terminée et qui présentent donc un faible risque de se reproduire.

À ce stade, les seconds évènements 21, 23, 24 ne sont pas traités. Les premiers évènements 22, 25, 26, c'est-à-dire ceux *a priori* non imputables aux modifications du réseau, sont ordonnancer 105 les uns par rapport aux autres par le dispositif central 10. Pour cela, des critères préétablis de pertinence et/ou de priorité sont appliqués. Les critères peuvent prendre de nombreuses formes en fonction du contexte et du résultat souhaité.

Dans l'exemple décrit ici, les critères suivants sont appliqués. Autrement dit, les paramètres suivants servent à ordonnancer les évènements les uns par rapport aux autres :
- nombre d'excursions constatées sur des intervalles prédéfinis de novembre à mars de l'année suivante (période de froid habituel en France pendant laquelle les réseaux de distribution électrique subissent les contraintes de charge les plus élevées). Par exemple, un premier nœud enregistrant quarante excursions de tension réparties sur cinq mois sans dépasser une valeur maximale prédéfinie pourra être considéré comme moins prioritaire qu'un deuxième nœud présentant dix excursions sur une même semaine ;
- nombre d'utilisateurs ou de nœuds concernés par un évènement ou un groupe d'évènements similaires (même date et même portion du réseau). Par exemple, une excursion de tension isolée, ayant des conséquences pratiques pour un unique utilisateur, sera considérée comme faiblement prioritaire car il est probable que la solution technique à apporter soit limitée à une intervention ponctuel sur le nœud concerné plutôt que sur une opération de grande envergure sur le réseau lui-même ;
- Amplitude des excursions, par exemple la différence entre la valeur atteinte lors de l'excursion de tension et la valeur nominale de tension (230 Volts pour la plupart des réseaux de distribution domestique français). Par exemple, un nœud enregistrant onze excursions de 27 Volts sur une semaine sera moins prioritaire qu'un nœud enregistrant huit excursions de 40 Volts sur la même période.

Une fois les premiers évènements ordonnancés les uns par rapport aux autres, le dispositif central 10 sélectionne une partie des premiers évènements en fonction de l'ordonnancement. Par exemple, les X% d'évènements les plus prioritaires sont retenus, X pouvant varier de 0 à 100. Autrement dit, l'intégralité des premiers évènements peut être sélectionnée, par exemple lorsque les capacités de traitement sont suffisantes. Dans un autre exemple, 25% des évènements les plus prioritaires sont sélectionnés. En variante, les critères de sélection peuvent être plus complexes et s'exprimer d'une autre manière que sous la forme d'une portion de la totalité des premiers évènements. Par exemple, la sélection peut être limitée à un nombre maximal prédéterminé d'évènements, indépendamment même du nombre de de premiers évènements ordonnancés à l'issue de l'opération d'ordonnancement qui précède.

L'opération de sélection 106 est mise en œuvre par le dispositif central 10 de manière automatisée. Cela n'exclut pas la possibilité, en outre, pour un opérateur, de sélectionner manuellement des évènements et de les ajouter à ladite sélection, par exemple pour répondre à une demande spécifique d'un utilisateur.

Il est maintenant fait référence à la [Fig. 2] représentant la suite du procédé. Les données des évènements retenus à l'issue de l'opération de sélection 106 sont enrichies par le dispositif central 10 par des données supplémentaires (ou complémentaires) collectées à cet effet des dispositifs 1, 3 locaux à l'origine desdits évènements. Ainsi, une fois les évènements les plus pertinents identifiés au moyen des étapes décrites ci-avant, des informations supplémentaires et détaillées sont obtenues uniquement pour les dispositifs locaux (ou nœuds) correspondant. Par exemple, le dispositif central 10 peut envoyer des requêtes ciblées à destination des dispositifs locaux 1, 3 (et non du dispositif local 5 dans l'exemple) pour obtenir en réponse des données supplémentaires. Par « données supplémentaires », on entend ici viser des données non transmises par défaut par les dispositifs locaux 1, 3, 5 (au cours de l'étape de collecte 102 notamment).

Les données supplémentaires peuvent notamment inclure des données de nature plus sensible que les données obtenues initialement, telles que des données de consommation précisément horodatées et/ou associées à des informations personnelles des utilisateurs. Par exemple, les données de « courbe de charge » peuvent être considérées comme sensibles au sens qu'elles peuvent contenir des informations relatives à la vie privée des usagers. Cependant, plutôt que de collecter de telles données sensibles de manière massive et automatique sans que l'intérêt d'une telle collecte soit précisément établie, l'acquisition et l'obtention de ces données est cette fois limitée à certains dispositifs locaux et justifiée par le besoin d'identifier et résoudre une anomalie technique préalablement identifiée.

Les données supplémentaires obtenues peuvent ensuite être combinées aux données obtenues préalablement (au cours de l'étape de collecte 102 notamment). L'ensemble de ces données sont ensuite à disposition du gestionnaire du réseau pour effectuer une analyse de la situation et de l'anomalie constatée. Ces données peuvent être traitées par des moyens automatisées de diagnostic et/ou par des opérateurs chargés d'effectuer de tels diagnostics.

À l'issu du procédé, on dispose donc de données détaillées seulement pour les nœuds pour lesquels une anomalie a été détectée, pour lesquels un diagnostic précis doit être établi et pour lesquels une intervention de maintenance est probablement à établir. Il est alors possible d'effectuer des simulations précises sur les nœuds concernés et leur environnement électrique. Par « environnement électrique », on vise en particulier les éléments appartenant au chemin électrique desdits nœuds et notamment les dipôles source qui présentent une forte probabilité d'être à l'origine des anomalies constatées au niveau des nœuds.

Des conditions de fonctionnement peuvent être simulées. Or, grâce aux données détaillées obtenues des dispositifs locaux en cours de diagnostic, les conditions simulées peuvent être sélectionnées similaires aux conditions réelles enregistrées dans le passé, et notamment les conditions réelles pendant lesquels les anomalies ont été relevées. Il est donc plus probable de réussir à simuler les anomalies passées rapidement qu'en surveillant le fonctionnement d'un nœud réel en « espérant » que les anomalies se reproduisent (méthode usuelle).

Une fois l'anomalie reproduite en simulation, il est en outre possible de simuler rapidement l'effet de nombreuses hypothèses de modifications afin d'identifier une solution technique, c'est-à-dire une ou plusieurs opérations de maintenance à effectuer pour corriger l'anomalie sans en créer d'autres. Par exemple, des rééquilibrages de phases (pour des lignes triphasées) et/ou des changements de prise sur un transformateur peuvent être testées. Bien entendu, la sélection des opérations de maintenance peut en outre avoir comme objectif de limiter les coûts et le nombre d'interventions nécessaires. Dans des modes de réalisation où l'on souhaite automatiser une grande partie des processus, il est possible de générer automatiquement des guides d'intervention destinés aux équipes d'opérateurs intervenant sur le terrain.

Ainsi, dans des modes de réalisation, le procédé peut ne pas s'arrêter à l'issue de l'opération d'enrichissement des données 107. Le procédé peut comprend certaines au moins des opérations ultérieures décrites ci-avant.

Les [Fig. 3] et [Fig. 4] montrent chacune un graphique représentant la tension (en Volts ; ordonnées) en fonction du temps (en heures ; abscisses) sur chacune des trois phases d'une ligne triphasée (chaque courbe correspondant à l'une des trois phases). La [Fig. 3] correspond à une situation simulée durant laquelle des excursions de tension sont observées tandis que la [Fig. 4] correspond à la même situation simulée à l'exception du fait qu'une intervention de maintenance a été considérée réalisée (rééquilibrage de phases).

### Application industrielle

Afin de comprendre le contexte de la présente divulgation, on précise ici que la demanderesse a notamment pour activité la gestion de réseaux de distribution d'électricité (en France et en Europe). À ce titre, outre ses obligations techniques en termes de qualité de fourniture de service, la demanderesse s'efforce de traiter les données conformément aux préconisations de la CNIL (« *Commission Nationale de l'Informatique et des Libertés* ») et des organismes analogues.

Les présentes solutions techniques peuvent trouver à s'appliquer notamment dans la gestion de réseaux de distribution électrique.

La présente divulgation ne se limite pas aux exemples de procédés, programmes informatiques et supports de d'enregistrement non transitoires décrits ci-avant, seulement à titre d'exemple.

### Liste des signes de référence

- 1 : dispositif local ;
- 3 : dispositif local ;
- 5 : dispositif local ;
- 10 : dispositif central ;
- 21 : premier événement ;
- 22 : second événement ;
- 23 : premier événement ;
- 24 : premier événement ;
- 25 : second événement ;
- 26 : second événement ;
- 101 : enregistrement ;
- 102 : collecte générale ;
- 103 : complétion ;
- 104 : comparaison ;
- 105 : ordonnancement ;
- 106 : sélection ;
- 107 : enrichissement par collecte ciblée.

## Revendications

1. Procédé de diagnostic d'un réseau électrique incluant une pluralité de nœuds, chaque nœud étant équipé d'un dispositif local (1, 3, 5) apte à mesurer au moins une propriété de l'énergie électrique transitant via le nœud correspondant, le procédé comprenant :
a. enregistrer (101) des événements (21, 22, 23, 24, 25, 26) par chaque dispositif local, chaque événement étant défini au moins par un identifiant du nœud et/ou du dispositif local, une date et une valeur quantifiant une anomalie dans l'au moins une propriété mesurée ;
b. effectuer une collecte générale (102) des enregistrements de chaque dispositif local, relatifs à une plage temporelle commune, sur un dispositif central (10) relié au réseau ;
c. compléter (103) chaque événement collecté par des données d'arborescence du réseau à la date de l'évènement, de sorte que des modifications du réseau pouvant avoir une influence sur l'au moins une propriété mesurée à la date de l'évènement soient identifiables ; **caractérisé en ce que** le procédé comprend en outre
d. comparer (104) les événements à des données d'historique de modifications du réseau de manière à distinguer des premiers événements (22, 25, 26) non imputables auxdites modifications de seconds évènements (21, 23, 24) imputables auxdites modifications ;
e. ordonnancer (105) les premiers évènements les uns par rapport aux autres en fonction de règles préétablies de pertinence et/ou de priorité ;
f. sélectionner (106) une partie des premiers évènements (22, 25) en fonction de l'ordonnancement ;
g. enrichir (107) les données de ladite sélection en effectuant une collecte ciblée de données supplémentaires de chaque dispositif local identifié dans ladite sélection.

2. Procédé selon la revendication précédente comprenant en outre, après l'opération d'enrichissement :
h. simuler, en au moins un nœud, au moins une situation déduite des données enrichies obtenues.

3. Procédé selon l'une des revendications précédentes comprenant en outre :
i. simuler, en au moins un nœud, une situation dans laquelle au moins une intervention sur le réseau a été effectuée par rapport à au moins une situation déduite des données enrichies obtenues.

4. Procédé selon la revendication 3, dans lequel l'au moins une intervention inclut au moins un rééquilibrage de phases d'une ligne triphasée et/ou un changement de prise d'un transformateur.

5. Procédé selon la revendication 3 ou 4, dans lequel l'au moins une intervention inclut au maximum trois interventions parmi des rééquilibrages de phases d'une ligne triphasée et des changements de prise d'un transformateur.

6. Procédé selon l'une des revendications précédentes comprenant en outre :
j. éditer au moins un rapport d'intervention en fonction d'un diagnostic déduit des données enrichies.

7. Programme informatique comportant des instructions pour la mise en œuvre du procédé selon l'une des revendications 1 à 6 lorsque ce programme est exécuté par un processeur.

8. Support d'enregistrement non transitoire lisible par un ordinateur sur lequel est enregistré un programme pour la mise en œuvre du procédé selon l'une des revendications 1 à 6 lorsque ce programme est exécuté par un processeur.

## Patentansprüche

1. Verfahren zur Diagnose eines elektrischen Netzwerks mit mehreren Knoten, wobei jeder Knoten mit einem lokalen Gerät (1, 3, 5) ausgestattet ist, das dazu in der Lage ist, mindestens eine Eigenschaft der durch den entsprechenden Knoten fließenden elektrischen Energie zu messen, wobei das Verfahren umfasst:
a) Aufzeichnen (101) von Ereignissen (21, 22, 23, 24, 25, 26) durch jedes lokale Gerät, wobei jedes Ereignis zumindest durch eine Kennung des Knotens und/oder des lokalen Geräts, ein Datum und einen Wert definiert ist, der eine Anomalie in der mindestens einen gemessenen Eigenschaft quantifiziert;
b) Durchführen einer allgemeinen Sammlung (102) der Aufzeichnungen jedes lokalen Geräts, die sich auf einen gemeinsamen Zeitbereich beziehen, auf einem zentralen Gerät (10), das mit dem Netzwerk verbunden ist;
c) Ergänzen (103) jedes gesammelten Ereignisses mit Baumstruktur-Daten des Netzwerks zum Datum des Ereignisses, so dass Modifikationen am Netzwerk identifizierbar sind, die einen Einfluss auf die mindestens eine am Datum des Ereignisses gemessene Eigenschaft haben können;
**dadurch gekennzeichnet, dass** das Verfahren weiter umfasst:
d) Vergleichen (104) der Ereignisse mit historischen Daten von Modifikationen des Netzwerks, um erste Ereignisse (22, 25, 26), die nicht den Modifikationen zuzuordnen sind, von zweiten Ereignissen (21, 23, 24), die den Modifikationen zuzuordnen sind, zu unterscheiden;
e) Ordnen (105) der ersten Ereignisse in Bezug aufeinander gemäß vorab festgelegter Regeln von Relevanz und/oder Priorität;
f) Auswählen (106) eines Teils der ersten Ereignisse (22, 25) gemäß der Ordnung;
g) Anreichern (107) der Daten der Auswahl durch Durchführen einer gezielten Sammlung zusätzlicher Daten von jedem in der Auswahl identifizierten lokalen Gerät.

2. Verfahren nach dem vorhergehenden Anspruch, ferner umfassend, nach dem Anreicherungsvorgang:
h) Simulation mindestens einer aus den erhaltenen angereicherten Daten abgeleiteten Situation in mindestens einem Knoten.

3. Verfahren nach einem der vorhergehenden Ansprüche, ferner umfassend:
i) Simulieren, in mindestens einem Knoten, einer Situation, in der mindestens ein Eingriff in das Netzwerk in Bezug auf mindestens eine aus den erhaltenen angereicherten Daten abgeleitete Situation durchgeführt wurde.

4. Verfahren nach Anspruch 3, wobei der mindestens eine Eingriff mindestens eine Phasen-Neujustierung einer Drehstromleitung und/oder eine Änderung der Anzapfung eines Transformators umfasst.

5. Verfahren nach Anspruch 3 oder 4, wobei der mindestens eine Eingriff höchstens drei Eingriffe umfasst aus Phasen-Neujustierungen einer Drehstromleitung und/oder Änderungen der Anzapfung eines Transformators.

6. Verfahren nach einem der vorhergehenden Ansprüche, ferner umfassend:
j) Editieren mindestens eines Eingriffsberichts in Abhängigkeit von einer aus den angereicherten Daten abgeleiteten Diagnose.

7. Computerprogramm mit Anweisungen zur Durchführung des Verfahrens nach einem der Ansprüche 1 bis 6, wenn dieses Programm von einem Prozessor ausgeführt wird.

8. Computerlesbarer, nichtflüchtiger Aufzeichnungsträger, auf dem ein Programm zur Durchführung des Verfahrens nach einem der Ansprüche 1 bis 6 aufgezeichnet ist, wenn dieses Programm von einem Prozessor ausgeführt wird.

## Claims

1. A method for diagnosing an electrical network including a plurality of nodes, each node being equipped with a local device (1, 3, 5) capable of measuring at least one property of the electrical energy passing through the corresponding node, the method comprising:
a. recording (101) events (21, 22, 23, 24, 25, 26) by each local device, each event being defined at least by an identifier of the node and/or of the local device, a date and a value quantifying an anomaly in the at least one measured property;
b. performing a general collection (102) of the records of each local device, relating to a common time range, on a central device (10) connected to the network;
c. supplementing (103) each event collected with network tree data at the date of the event, so that changes to the network that may have an influence on the at least one property measured at the date of the event are identifiable;
**characterised in that** the method further comprises
d. comparing (104) the events with history data of changes in the network so as to distinguish between first events (22, 25, 26) not attributable to said modifications from second events (21, 23, 24) attributable to said modifications;
e. scheduling (105) the first events with respect to each other according to preestablished rules of relevance and/or priority;
f. selecting (106) part of the first events (22, 25) according to the scheduling;
g. enriching (107) the data of said selection by performing a targeted collection of additional data from each local device identified in said selection.

2. The method according to the preceding claim further comprising, after the enrichment operation:
h. simulating, in at least one node, at least one situation deduced from the enriched data obtained.

3. The method according to one of the preceding claims further comprising:
i. simulating, in at least one node, a situation wherein at least one intervention on the network has been carried out with respect to at least one situation deduced from the enriched data obtained.

4. The method according to claim 3, wherein the at least one intervention includes at least one phase rebalancing of a three-phase line and/or a change of tap of a transformer.

5. The method according to claim 3 or 4, wherein the at least one intervention includes at most three interventions among phase rebalances of a three-phase line and tap changes of a transformer.

6. The method according to one of the preceding claims further comprising:
j. editing at least one intervention report based on a diagnosis deduced from the enriched data.

7. A computer program including instructions for implementing the method according to one of claims 1 to 6 when this program is executed by a processor.

8. A non-transient recording medium readable by a computer on which is recorded a program for implementing the method according to one of claims 1 to 6 when this program is executed by a processor.
